# EUROPEAN PATENT APPLICATION

(11) **EP 0 584 688 A2**
(43) Date of publication of application: **02.03.1994**
(21) Application number: 93113106.4
(22) Date of filing: 16.08.1993
(51) Int. Cl.: G11C 11/412

(54) **Memory device**

(30) Priority: 21.08.1992 JP 245696/92
(71) Applicant: YOZAN INC., Tokyo 155 (JP); SHARP KABUSHIKI KAISHA, Osaka 545 (JP)
(72) Inventor: Shou, Guoliang, Setagaya-ku, Tokyo 155 (JP); Takatori, Sunao, Setagaya-ku, Tokyo 155 (JP); Yamamoto, Makoto, Setagaya-ku, Tokyo 155 (JP)
(74) Representative: Grünecker, Kinkeldey, Stockmair & Schwanhäusser Anwaltssozietät

(57) **Abstract**

The present invention has an object to provide a memory device without the necessity of refreshment, whose circuit is small size.

The memory device has a memory cell "MC" comprising: i) the first FET of P-channel having a gate "G1" connected input voltage "Vi" and source "S1" grounded through protect resistance "R1"; ii) the second FET of N-channel having a gate "G2" connected to a drain "D1" of the first FET, a drain "D2" connected to power source "Vcc", and a source "S2" connected to a gate "G1" of the first FET through protect resistance "R2"; and
iii) a switch "SWR" connecting the gate "G2" of the second FET and power source "Vcc". Self-holding circuit is formed by the pair of FETs.

## Description

### FIELD OF THE INVENTION

The present invention relates to a memory device, especially to that without necessity of refreshment.

### BACKGROUND OF THE INVENTION

Conventionally, static RAM generally constructs a memory cell by a flip-flop. There are problems that the size of the circuit is rather large, the memory capacity is small and it is expensive to make it using flip-flop.

### SUMMARY OF THE INVENTION

The present invention solves the above-mentioned problems of the prior art and has an object to provide a memory device without the necessity of refreshment, whose circuit is small size.

A memory device of this invention constructs a self-holding circuit by a couple of transistors.

### BRIEF DESCRIPTION OF THE DRAWINGS

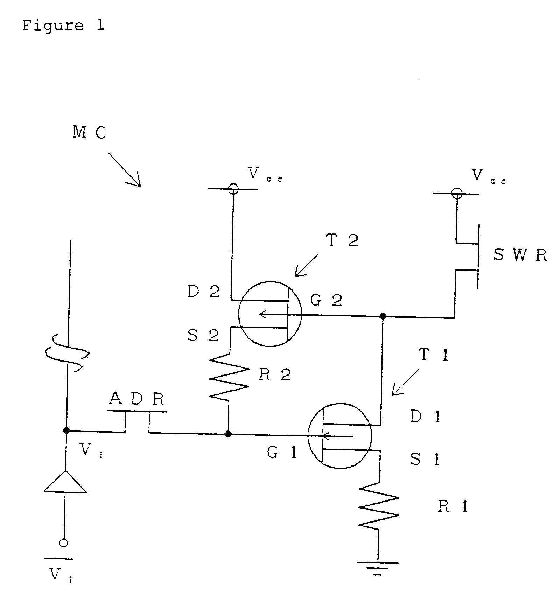

Figure 1 shows an embodiment of a memory cell in the memory device of this invention.

### PREFERRED EMBODIMENT OF THE PRESENT INVENTION

Hereinafter, an embodiment of a memory device according to the present invention is described with reference to the attached drawings.

The memory device comprises a memory cell MC which retains 1 bit data in Figure 1.

The memory cell MC makes a self-retention circuit having the first MOSFET of P-channel ("T1", hereinafter,) whose input voltage "Vi" is connected to gate "G1" and the second MOSFET of N-channel ("T2", hereinafter), whose gate "G2" is connected to drain "D1" of T1.

Drain "D2" and source "S2" of T2 are connected to power source Vcc and gate G1 of T1 respectively. Source S1 of T1 is grounded. When T1 becomes conductive due to excess of Vi over threshold, a circuit is formed from drain D1 of T1 to the ground through source S1 and gate G2 of T2 becomes low level. Consequently, a circuit is formed from power source Vcc to gate G1 through drain D2 and source S2, and the level of gate G2 is kept in high level.

As above, a memory device without necessity of refreshment can be realized by means of very small circuit by forming a self-retention circuit having a pair of transistors. In this circuit, the status is retained by voltage and consuming electric power is extremely small because the integrated transistor is FET.

Input voltage Vi is connected to gate G1 through address switch ADR which is opened and closed according to the output of address decorder.

In order to reset memory cell MC in high level, it is necessary to make gate G2 high level or G1 low level. Switch SWR is set by connecting it to power source Vcc, for example, so as to execute it.

Source S1 is grounded through protect resistance R1 in order to protect T1 on the refreshment. Source S2 is connected to gate G1 through protect resistance R2 in order to protect T2 in high level.

As mentioned above, a memory device according to the present invention forms a self-retention circuit by a pair of FET (Field of Effect Transistor). Therefore, the refreshment is unnecessary and the size of the circuit is small.

## Claims

1. A memory device having a memory cell comprising:
i) the first FET of P-channel having a gate connected input voltage and source grounded;
ii) the second FET of N-channel having a gate connected to a drain of said first FET, a drain connected to power source, and a source connected to a gate of said first FET; and
iii) a switch connecting said gate of said second FET and power source.

2. A memory device claimed in claim 1, including a memory dell further comprised of a source of said first FET grounded through protect resistance.
